# EUROPEAN PATENT APPLICATION

(11) **EP 4 560 859 A1**
(43) Date of publication of application: **28.05.2025**
(21) Application number: 24189051.6
(22) Date of filing: 17.07.2024
(51) Int. Cl.: H02H 1/00, G01R 31/08, H02H 7/122, H02H 7/20

(54) **METHOD FOR PROCESSING ARC FAULT, INVERTER AND PHOTOVOLTAIC SYSTEM**

(30) Priority: 23.11.2023 CN 202311577115
(71) Applicant: Sungrow Power Supply Co., Ltd., Hefei, Anhui 230088 (CN)
(72) Inventor: ZHOU, Yinyin, Hefei, Anhui (CN); YANG, Yongchang, Hefei, Anhui (CN); WANG, Wei, Hefei, Anhui (CN); HUANG, Zhifeng, Hefei, Anhui (CN); XING, Jun, Hefei, Anhui (CN); ZHANG, Ran, Hefei, Anhui (CN)
(74) Representative: Zacco Norway AS

(57) **Abstract**

A method for processing arc fault, an inverter and a photovoltaic system are provided in the present disclosure. The method includes: after an inverter detects suspected arc, stopping outputting a control signal to a first DC/DC conversion circuit where suspected arc occurs, and maintaining remaining DC/DC conversion circuits operating normally (S401); waiting for a first preset period (S402), determining whether a current at the power supply side of the first DC/DC conversion circuit is less than a first preset current (S405); determining that arc fault occurs, in a case that the current at the power supply side is less than the first preset current (S405, S406). According to the present disclosure, the control signal is only stopped being output to the first DC/DC conversion circuit where the suspected arc occurs, resulting in minimum power fluctuation in an entire detection and control process. By detecting the change of current in the first DC/DC conversion circuit, whether the suspected arc is the arc fault is determined, thereby improving the effect of arc phenomenon detection.

Fig. 4

## Description

### FIELD

The present disclosure relates to the field of photovoltaic system, and in particular to a method for processing arc fault, an inverter and a photovoltaic system.

### BACKGROUND

In conventional technology, in a case that a suspected arc is detected, all DC/DC conversion circuits are controlled to stop operating. This reduces the direct current flowing through an inverter to 0A to make the arc phenomenon disappear. Then the inverter is controlled to be turned on rapidly. In a case that a direct-current power supply does not output current, the suspected arc is determined to be an arc fault. Subsequently, the arc fault is reported to users, indicating that such hazard is required to be eliminated.

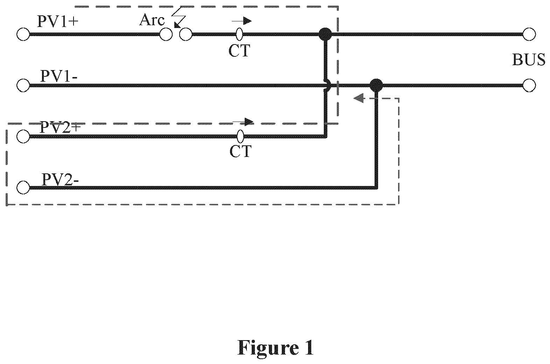

After all DC/DC conversion circuits are wave blocked, due to the direct-current power supplies are connected in parallel, the current flowing through the high voltage inputted by wave blocking to the low voltage forms a current loop, as shown in Figure 1, which bypasses the inverter. In this case, it becomes challenging to determine the change in direct current at the power supply side of the DC/DC conversion circuit, compromising the effect of arc phenomenon detection.

### SUMMARY

In view of this, a method for processing arc fault, an inverter and a photovoltaic system are provided according to embodiments of the present disclosure, to address the problem that the effect of arc phenomenon detection is compromised in conventional technology.

In order to achieve above objective, technical solutions are provided according to embodiments of the present disclosure as follows.

In a first aspect of the embodiments of the present disclosure, a method for processing arc fault is provided, which is applied to an inverter. Where, the inverter includes an inversion circuit and at least one DC/DC conversion circuit connected to a direct-current side of the inverter, where the method includes:
in a case that a suspected arc is detected, stopping outputting a control signal to a first DC/DC conversion circuit where the suspected arc occurs, and maintaining remaining DC/DC conversion circuits operating normally;
waiting for a first preset period, and determining whether a current at a power supply side of the first DC/DC conversion circuit is less than a first preset current; and
determining that an arc fault occurs, in a case that the current at the power supply side is less than the first preset current.

In an embodiment, after waiting for the first preset period and before the determining whether the current at the power supply side of the first DC/DC conversion circuit is less than the first preset current, the method further includes:
determining whether each current of at least one direct-current power supply connected to the power supply side of the first DC/DC conversion circuit is greater than a second preset current respectively; and
in a case that any current of the at least one direct-current power supply connected to the power supply side of the first DC/DC conversion circuit is less than the second preset current, determining whether the current at the power supply side of the first DC/DC conversion circuit is less than the first preset current.

In an embodiment, after the determining whether each current of the at least one direct-current power supply connected to the power supply side of the first DC/DC conversion circuit is greater than the second preset current respectively, and before the determining whether the current at the power supply side of the first DC/DC conversion circuit is less than the first preset current, the method further includes:
controlling a voltage at the power supply side of the first DC/DC conversion circuit to be less than a safety voltage, in a case that each current of the at least one direct-current power supply connected to the power supply side of the first DC/DC conversion circuit is greater than the second preset current; and
waiting for a second preset period, and adjusting the voltage at the power supply side of the first DC/DC conversion circuit to be a voltage value before stopping outputting the control signal; and
determining whether the current at the power supply side of the first DC/DC conversion circuit is less than the first preset current.

In an embodiment, the controlling the voltage at the power supply side of the first DC/DC conversion circuit to be less than the safety voltage includes: resuming outputting the control signal to the first DC/DC conversion circuit, and adjusting a duty ratio of the control signal, to enable the voltage at the power supply side of the first DC/DC conversion circuit is less than the safety voltage.

In an embodiment, the determining whether each current of the at least one direct-current power supply connected to the power supply side of the first DC/DC conversion circuit is greater than the second preset current respectively includes:
calculating an absolute value of each current of the at least one direct-current power supplies connected to the power supply side of the first DC/DC conversion circuit; and
determining whether a minimum value among the absolute values is greater than the second preset current.

In an embodiment, after determining whether the current at the power supply side of the first DC/DC conversion circuit is less than the first preset current, the method further includes: determining, in a case that the current at the power supply side is greater than or equal to the first preset current, that no arc fault occurs.

In an embodiment, the method further includes: recording, in a case that the suspected arc is detected, a voltage value and a current value of the first DC/DC conversion circuit where the suspected arc occurs.

In an embodiment, the method further includes: on determining that the arc fault occurs, generating and outputting alarm information.

In a second aspect of the embodiments of the present disclosure, an inverter is provided. The inverter includes a controller, an inversion circuit and at least one DC/DC conversion circuit, where a power supply side of the at least one DC/DC conversion circuit, serving as an interface corresponding to a direct-current side of the inverter, is configured to be connected to at least one direct-current power supply; a bus side of the DC/DC conversion circuit is connected to a direct-current side of the inversion circuit through a direct-current bus; an alternating-current side of the inversion circuit, serving as an alternating-current side of the inverter, is configured to be connected to a power grid and/or an alternating-current load; the controller is configured to control the inversion circuit and the DC/DC conversion circuit; and the controller is further configured to implement the method for processing arc fault according to the above first aspect of the present disclosure.

In an embodiment, the direct-current power supply includes a photovoltaic string or a battery cluster.

In a third aspect of the embodiments of the present disclosure, a photovoltaic system is provided. The photovoltaic system includes a photovoltaic string and the inverter according to the above second aspect of the present disclosure.

Based on the method for processing arc fault, the inverter and the photovoltaic system provided in the embodiments of the present disclosure, the inverter includes the inversion circuit and at least one DC/DC conversion circuit connected to the direct-current side of the inversion circuit. The method for processing arc fault includes: stopping outputting a control signal of the first DC/DC conversion circuit where a suspected arc occurs after the suspected arc is detected, and maintaining remaining DC/DC conversion circuits operating normally; determining, after waiting for the first preset period, whether the current at the power supply side of the first DC/DC conversion circuit is less than the first preset current; determining that the arc fault occurs in a case that the current at the power supply side is less than the first preset current. According to the embodiments of the present disclosure, the control signal is only stopped being output to the first DC/DC conversion circuit where the suspected arc occurs, causing minimum power fluctuation in an entire detection and control process, which does not impact on power generation quantity of a power station and a power grid. By detecting the change of current in the first DC/DC conversion circuit, whether the suspected arc is the arc fault is determined. In a case that the current at the power supply side is less than the first preset current, it is determined that the arc fault occurs, thereby improving the effect of arc phenomenon detection.

### BRIEF DESCRIPTION OF THE DRAWINGS

For more clearly illustrating embodiments of the present disclosure or technical solutions in the conventional technology, the drawings used to describe the embodiments or the conventional technology are briefly described hereinafter. Apparently, the drawings in the following description are only some examples of the present disclosure, and for a person skilled in the art, other drawings may be obtained based on the provided drawings without any creative efforts.
Figure 1 is a schematic structural diagram of a current loop in conventional technology according to an embodiment of the present disclosure;
Figure 2 is a schematic structural diagram of an inverter according to an embodiment of the present disclosure;
Figure 3 is a schematic structural diagram of a photovoltaic system according to an embodiment of the present disclosure;
Figure 4 is a flowchart of a method for processing arc fault according to an embodiment of the present disclosure;
Figure 5 is a flowchart of a process for processing arc fault according to an embodiment of the present disclosure; and
Figure 6 is a schematic structural diagram of a device for processing arc fault according to an embodiment of the present disclosure.

### DETAILED DESCRIPTION

Technical solutions of embodiments of the present disclosure are clearly and thoroughly described hereinafter in conjunction with the drawings of the embodiments of the present disclosure. Apparently, the embodiments described in the following are only some embodiments of the present disclosure, rather than all embodiments. Based on the embodiments in the present disclosure, all other embodiments which are obtained by those skilled in the art without any creative efforts fall within the protection scope of the present disclosure.

The terms such as "first", "second", "third", "fourth" and the like (if any) in the specification, claims and drawings of the present disclosure are only used to distinguish similar objects, rather than describe a particular order or sequence. It should be understood that terms discussed above may be exchanged when appropriate, such that the embodiments of the present disclosure described herein can be implemented in an order different from the content shown or described herein. Moreover, the terms "include," "comprise", and any other variants thereof are intended to cover the non-exclusive inclusion. For example, a process, a method, a system, a product, or a device that includes a list of steps or units is not necessarily limited to those expressly listed steps or units, but may include other steps or units not expressly listed or inherent in such process, method, product, or device.

It should be noted that, the terms "first", "second" and the like are used only for description and should not be construed as indicating or implying relative importance or implying the number of the indicated technical features. Hence, features defined with "first" or "second" may include at least one of the features explicitly or implicitly. In addition, the technical solutions of the various embodiments can be combined with each other, based on the ways that can be implemented by a person skilled in the art. When the combination of technical solutions is contradictory or cannot be enabled, it should be considered that such a combination of technical solutions does not exist, and is not within the protection scope of the present disclosure.

In the present disclosure, terms such as "comprise", "include", or any other variation thereof are intended to cover non-exclusive inclusion, such that a process, a method, article, or device that includes a series of elements not only includes the series of elements, but also other elements not explicitly listed, or further includes elements inherent in such a process, method, article, or device. Unless expressively limited otherwise, a process, method, article or a device limited by "comprising/including a(n) ..." does not exclude existence of another identical element in such process, method, article or device.

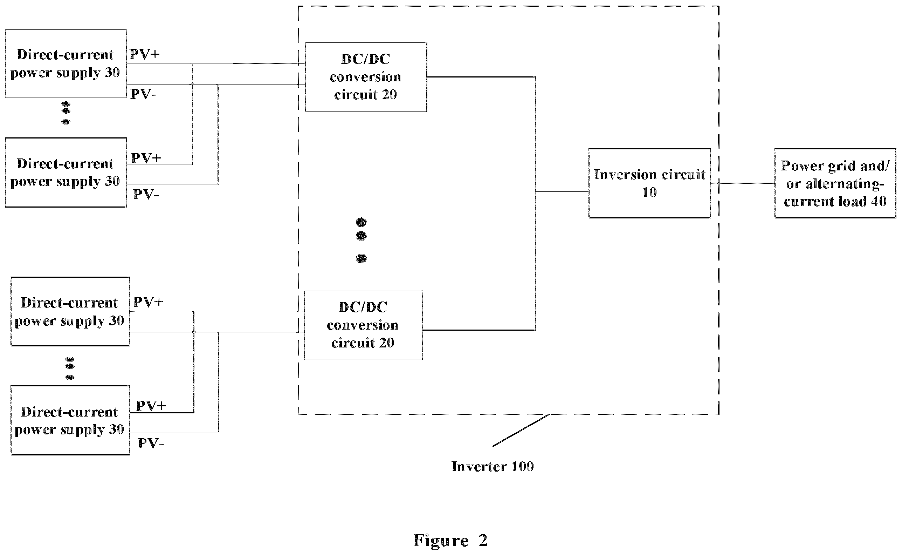

Referring to Figure 2, Figure 2 is a schematic structural diagram of an inverter according to an embodiment of the present disclosure.

The inverter 100 includes a controller (not shown in Figure 2), an inversion circuit 10 and at least one DC/DC conversion circuit 20.

Where, a power supply side of the DC/DC conversion circuit 20 serves as an interface corresponding to a direct-current side of the inverter, which is configured to be connected to at least one direct current power supply 30.

A bus side of the DC/DC conversion circuit 20 is connected to the direct-current side of the inversion circuit 10 through a direct-current bus.

An alternating-current side of the inversion circuit 10 serves as an alternating-current side of the inverter, which is configured to be connected to a power grid and/or alternating-current load 40.

It should be noted that a side of the DC/DC conversion circuit 20 connected to the direct-current power supply 30 is referred to as the power supply side, a side of the DC/DC conversion circuit 20 connected to the inversion circuit 10 is referred to as the bus side.

Both the inversion circuit 10 and the DC/DC conversion circuit 20 are controlled by the controller.

It should be noted that the direct-current side of the inverter 100 includes multiple interfaces, each one of the multiple interfaces is a side of the DC/DC conversion circuit 20.

According to an embodiment, the direct-current power supply 30 may be a photovoltaic string or a battery cluster.

In the embodiment of the present disclosure, in a case that the direct-current power supply 30 is a battery cluster, the inverter 100 can operate bi-directionally, i.e., both charge and discharge can be performed. For example, in the discharge state, the DC/DC conversion circuit 20 boosts the voltage from the battery cluster to the inversion circuit 10; in the charge state, the DC/DC conversion circuit 20 reduces the voltage from the inversion circuit 20 to the battery cluster. In view of this, the DC/DC conversion circuit 20 is not only a boost circuit BOOST.

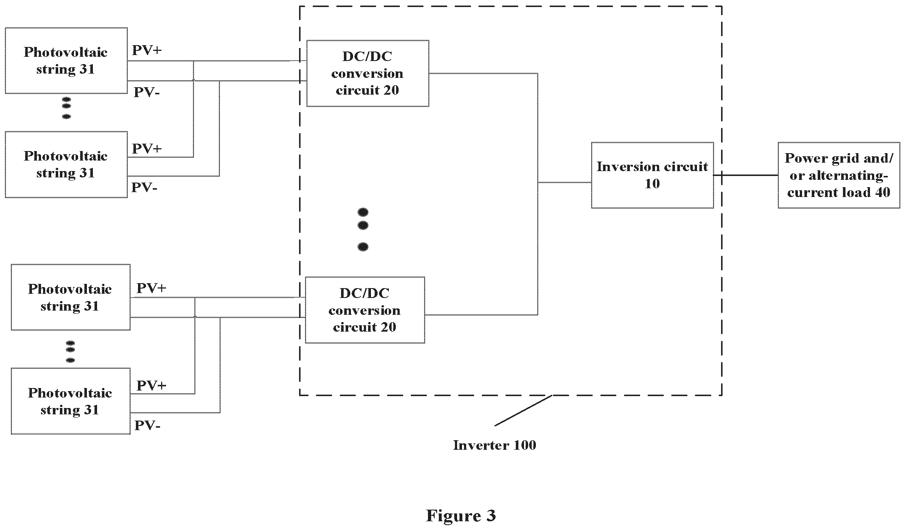

In an embodiment, in a case that the direct-current power supply 30 is a photovoltaic string 31, the inverter 100 is arranged in the photovoltaic system 10, as shown in Figure 3, the photovoltaic system includes the photovoltaic string 31 and the inverter 100 shown in Figure 2.

The interface corresponding to the direct-current side of the inverter 100 is connected to at least one of the multiple photovoltaic strings 31. The alternating-current side of the inverter 31 is connected to the power grid and/or the alternating-current load 40.

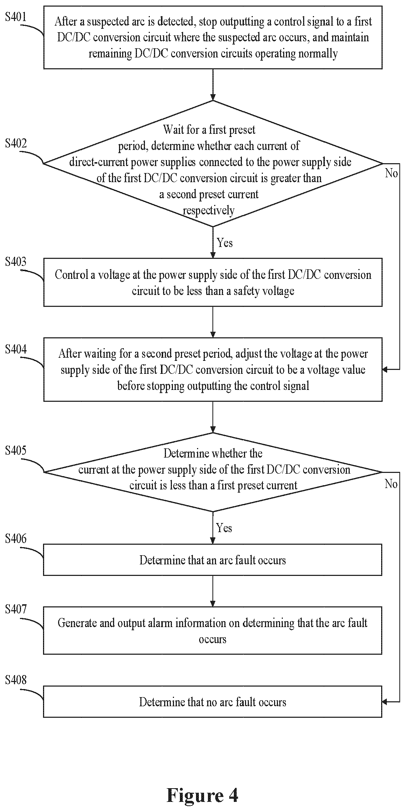

Based on the structures shown in the above embodiments of the present disclosure, the process of processing arc fault is implemented through the controller in the inverter 100, as shown in Figure 4. Figure 4 illustrates a method for processing arc fault according to an embodiment of the present disclosure. The method includes steps S401 to S408 as follows.

In step S401, after a suspected arc is detected, the control signal is stopped being outputted to the first DC/DC conversion circuit where the suspected arc occurs, and the remaining DC/DC conversion circuits maintain operating normally.

It should be noted that the suspected arc refers to a false arc phenomenon caused by voltage disturbance, or a true arc phenomenon. Where, the arc phenomenon is a form of an arc fault.

In this embodiment, Step S401 may be also referred to as wave blocking. Wave blocking involves stopping the transmission of a control signal to the switching device in the DC/DC circuit, consequently keeping the switching device in the turned-off state.

In the process of implementing the step S401, the controller, first, detects whether a suspected arc occurs on the inverter in real-time. In a case that the suspected arc is detected, the DC/DC conversion circuit on which the suspected arc is detected is determined as a first DC/DC conversion circuit.

It should be noted that the quantity of the first DC/DC conversion circuit may be one or more.

For example, in an embodiment, in a case that a suspected arc is detected in the branch between PV1 of the direct-current power supply and the DC/DC conversion circuit, the DC/DC conversion circuit A1 in the branch is set as the first DC/DC conversion circuit.

In another embodiment, in a case that a suspected arc is detected in the first branch between the PV1 of the direct-current power supply and the DC/DC conversion circuit, and a suspected arc is also detected in the second branch between PV3 of the direct current power supply and the DC/DC conversion circuit, both the DC/DC conversion circuit A1 in the first branch and the DC/DC conversion circuit A2 in the second branch are set as first DC/DC conversion circuits. In this case, the quantity of the first DC/DC conversion circuits is two.

It should be noted that the specific process of maintaining the normal operation of the remaining DC/DC conversion circuits is that the controller keeps the operating powers of the remaining DC/DC conversion circuits unchanged.

Then, the controller first controls the switching devices in the remaining DC/DC conversion circuits to be turned on, so that the operating powers of the remaining DC/DC conversion circuits remain unchanged. And, the controller only stop sending the control signal to the first DC/DC conversion circuit where the suspected arc occurs, so that the switching device in the first DC/DC conversion circuit remains in the turned-off state. In other words, the first DC/DC conversion circuit is subjected to wave blocking.

In an embodiment, after the suspected arc is detected, the voltage value and current value of the first DC/DC conversion circuit where the suspected arc occurs are recorded. In other words, the voltage value *Vₚᵣₑ* and current value *Iₚᵣₑ* of the first DC/DC conversion circuit where the suspected arc occurs before stopping outputting the control signal are recorded.

In step S402, the first preset period is waited, it is determined that whether each current of at least one direct-current power supply connected to the power supply side of the first DC/DC conversion circuit is greater than a second preset current respectively. In a case that each current of the at least one direct-current power supply connected to the power supply side of the first DC/DC conversion circuit is greater than a second preset current respectively, step S403 is executed. Otherwise, step S404 is directly executed. Where, the at least one direct-current power supply may include one direct-current power supply or multiple direct-current power supplies, which can be set according to practical application and is not limited in the present disclosure. As an example, the at least one direct-current power supply may hereinafter be multiple direct-current power supplies, as shown in Figure 2 and 3, for illustration purpose only.

It should be noted that there are many implementations in the process of the step S402.

In a first implementation, steps S11 to S12 are includes as follows.

In step S11, absolute values of currents of all direct-current power supplies connected to the power supply side of the first DC/DC conversion circuit are calculated.

In the process of implementing step S11, the controller collects currents of all direct-current power supplies connected to the power supply side of the first DC/DC conversion circuit after a second preset period, and calculates the absolute value of the current of each direct-current power supply connected to the power supply side of the first DC/DC conversion circuit respectively.

It should be noted that, the first preset period is set based on a port impedance corresponding to the inverter, that is, the first preset period is related to the port impedance of the inverter, such as T1=RC, and a corresponding period is 200ms.

In step S12, it is determined that whether a minimum value among the absolute values is greater than the second preset current *Iₛₑₜ₁*; in a case that the minimum value is greater than the second preset current *Iₛₑₜ₁*, step S403 is executed; in a case that the minimum value is less than or equal to the second preset current *Iₛₑₜ₁*, step S406 is directly executed.

In the process of implementing the step S12, the absolute values of the currents of the direct-current power supplies connected to the power supply side of the first DC/DC conversion circuit are compared with each other to determine the minimum value; and whether the minimum value is greater than the second preset current *Iₛₑₜ₁* is determined; if so, step S403 is executed; otherwise, step S404 is directly executed.

In a second implementation, steps S21 to S22 are included as follows.

In step S21, the absolute values of the currents of all direct-current power supplies connected to the power supply side of the first DC/DC conversion circuit are calculated.

It should be noted that the specific implementation process of the step S21 is the same as the implementation process of the above step S11, which can be referred to each other.

In step S22, whether the absolute value of the current of each of the direct-current power supplies is greater than the second preset current *Iₛₑₜ₁* is determined. In a case that the absolute value of the current of each of the direct-current power supplies is greater than the second preset current *Iₛₑₜ₁*, then step S403 is executed. In a case that the absolute value of the current of any one of direct-current power supplies is less than or equal to the second preset current *Iₛₑₜ₁*, step S406 is directly executed.

In the process of implementing step S22, the absolute value of the current of each of the direct-current power supplies connected to the power supply side of the first DC/DC conversion circuit is compared with the second preset current *Iₛₑₜ₁* respectively. It is determined that whether the absolute value of the current of any one of the direct-current power supplies is less than or equal to the second preset current *Iₛₑₜ₁.* In a case that the absolute value of the current of each of the direct-current power supplies is greater than the second preset current *Iₛₑₜ₁*, then step S403 is executed. In a case that the absolute value of the current of any one of the direct-current power supplies is less than or equal to the second preset current *Iₛₑₜ₁*, Step S406 is directly executed.

In step S403, a voltage at the power supply side of the first DC/DC conversion circuit is controlled to be less than a safety voltage.

In the process of implementing step S403, the control signal is resumed to output to the first DC/DC conversion circuit, and the duty ratio of the control signal is adjusted, so that the voltage at the power supply side of the first DC/DC conversion circuit is less than the safety voltage. In other words, by adjusting the duty ratio of the control signal, the voltage of the first DC/DC conversion circuit is controlled to be reduced. Further, whether the reduced voltage of the first DC/DC conversion circuit is less than the safety voltage is detected in real-time, to ensure the current voltage at the power supply side of the first DC/DC conversion circuit being less than the safety voltage.

Where, the safety voltage is a voltage set by the technicians according to experiment or practice.

It should be noted that in addition to controlling the voltage at the power supply side of the first DC/DC conversion circuit to be less than the safety voltage by adjusting the duty ratio of the control signal as shown above, there are other implementations that can control the voltage at the power supply side voltage of the first DC/DC conversion circuit to be less than the safety voltage.

In an implementation, steps S31 to S32 are included as follows.

In step S31, the voltage at the power supply side of the first DC/DC conversion circuit is controlled to be reduced based on a preset voltage reduction rule.

In step S31, the voltage at the power supply side of the first DC/DC conversion circuit is the voltage value *Vₚᵣₑ* before stopping outputting the control signal, or the voltage value that is reduced based on the preset voltage reduction rule.

In other words, before stopping outputting the control signal to the first DC/DC conversion circuit, the voltage value *Vₚᵣₑ* of the first DC/DC conversion circuit is collected and determined as the voltage at the power supply side of the first DC/DC conversion circuit. Alternatively, a previous voltage at the power supply side of the first DC/DC conversion circuit is determined as the voltage at the power supply side of the first DC/DC conversion circuit; where, the previous voltage is the voltage that has been previously reduced, based on the preset voltage reduction rule.

It should be noted that, the preset voltage reduction rule is set by technicians according to practice or experiment. Where, the preset voltage reduction rule may be a constant voltage reduction rule, or an arithmetic voltage reduction rule.

The fixed voltage reduction rule refers to reducing the voltage at the power supply side of the first DC/DC conversion circuit each time according to a set voltage, such as reducing 5V for each time.

The arithmetic voltage reduction rule refers to reducing the voltage at the power supply side of the first DC/DC conversion circuit each time according to the arithmetic sequence, such as reducing 5V for a first time, reducing 4V for a second time, and so on until the voltage at the power supply side is reduced to 1V.

Since the preset voltage reduction rule may be the constant voltage reduction rule, or the arithmetic voltage reduction rule, there are multiple implementations in the process of implementing the step S21.

In a first implementation, firstly, whether the preset voltage reduction rule is a constant voltage reduction rule is determined. In a case that the preset voltage reduction rule is the constant voltage reduction rule, the voltage at the power supply side of the first DC/DC conversion circuit is controlled to be reduced according to the set voltage in the constant voltage reduction rule, to obtain the reduced voltage at the power supply side of the first DC/DC conversion circuit.

For example, according to the constant voltage reduction rule, the voltage reduction for each time is set to be 5V, where i represents times of voltage reduction. The voltage before stopping outputting the control signal is 20V, whether the current voltage at the power supply side of the first DC/DC conversion circuit is 20V is determined. In a case that the current voltage at the power supply side of the first DC/DC conversion circuit is 20V, this is the first time that the voltage at the power supply side of the first DC/DC conversion circuit is about to be reduced, i.e., i=1. In this case, according to the constant voltage reduction rule, the first voltage 20V is controlled to be reduced for the first time, i.e., reducing 5V for the first time, to obtain the voltage of 15V of the power supply side of the first DC/DC conversion circuit.

In a case that the current voltage at the power supply side of the first DC/DC conversion circuit is not 20V, the difference between the current voltage at the power supply side of the first DC/DC conversion circuit and 20V is calculated. In a case that the difference is 5V, it is indicated that a first voltage reduction has been performed, a second voltage reduction is then performed, i.e., i=2, and the above voltage reduction method is repeated.

In a second implementation, firstly, whether the preset voltage reduction rule is the arithmetic voltage reduction rule is determined. In a case that the preset voltage reduction rule is the arithmetic voltage reduction rule, whether the voltage at the power supply side of the first DC/DC conversion circuit is the voltage before stopping outputting the control signal is determined. In a case that the voltage at the power supply side of the first DC/DC conversion circuit is the voltage before stopping outputting the control signal, it is indicated that this is the first time that the voltage is about to be reduced. In this case, the voltage at the power supply side of the first DC/DC conversion circuit may be controlled to be reduced for the first time, according to the arithmetic voltage reduction rule. In a case that the voltage at the power supply side of the first DC/DC conversion circuit is not the voltage before stopping outputting the control signal, based on the reducing voltage setting in the arithmetic voltage reduction rule, it is determined that this is the voltage reduction for the j-th time. Then the voltage at the power supply side of the first DC/DC conversion circuit is controlled to be reduced for the j-th time, according to the arithmetic voltage reduction rule.

Where, j is a positive integer and greater than or equal to 2, and j cannot be greater than times of reductions that can be performed in the arithmetic voltage reduction rule.

For example, in the arithmetic voltage reduction rule, the voltage is reduced sequentially according to the voltages of 5V, 4V, 3V, 2V, and 1V with a difference of 1V, and the value of j must not be greater than 5. The voltage value at the power supply side of the first DC/DC conversion circuit before stopping outputting the control signal is 20V. Whether the current voltage at the power supply side of the current first DC/DC conversion circuit is 20V is determined. In a case that the current voltage at the power supply side of the current first DC/DC conversion circuit is 20V, it is indicated that the voltage at the power supply side of the first DC/DC conversion circuit is about to be reduced for the first time, i.e., j=1. In this case, the voltage of 20V at the power supply side of the first DC/DC conversion circuit may be controlled to be reduced for the first time according to the arithmetic voltage reduction rule. In other words, the voltage is reduced 5V for the first time to obtain a reduced first voltage of 15V. In a case that the current voltage at the power supply side of the current first DC/DC conversion circuit is not 20V, the difference between the current voltage at the power supply side of the first DC/DC conversion circuit and 20V is calculated. In a case that the difference is 5, it is indicated that a first voltage reduction has been performed, a second voltage reduction is then performed, i.e., j=2. According to the arithmetic voltage reduction rule, the voltage of 15V at the power supply side of the first DC/DC conversion circuit is controlled to be reduced for the second time to obtain the voltage of 11V at the power supply side of the first DC/DC conversion circuit, and so on. In a case that the difference is 9, it is indicated that the second voltage reduction has already been performed, a third voltage reduction is performed, i.e., j=3.

In step S32, whether the reduced voltage *V_{red}* at the power supply side of the first DC/DC conversion circuit is less than or equal to the safety voltage *Vₛₑₜ* is determined. In a case that the reduced voltage *V_{red}* at the power supply side of the first DC/DC conversion circuit is less than or equal to the safety voltage *Vₛₑₜ*, it is determined that the voltage at the power supply side voltage of the first DC/DC conversion circuit has been controlled to be less than the safety voltage. In a case that the reduced voltage *V_{red}* at the power supply side of the first DC/DC conversion circuit is greater than the safety voltage *Vₛₑₜ*, it returns back to step S11.

In step S404, after waiting for the second preset period, the voltage at the power supply side of the first DC/DC conversion circuit is adjusted to be the voltage before stopping outputting the control signal.

It should be noted that the second preset period is set by technicians according to multiple experiments or practice, to ensure that the arc phenomenon is reliably eliminated, the second preset period is generally set to be 2s.

In the process of implementing step S404, a normal duty ratio of the control signal is resumed to adjust the voltage at the power supply side of the first DC/DC conversion circuit to the voltage before stopping outputting the control signal, i.e., the voltage at the power supply side of the first DC/DC conversion circuit is adjusted back to the voltage before stopping outputting control signal.

In step S405, whether the current at the power supply side of the first DC/DC conversion circuit is less than a first preset current is determined. In a case that the current at the power supply side is less than the first preset current, step S406 is executed. In a case that the current at the power supply side is greater than or equal to the first preset current, step S408 is executed.

In step S405, the first preset current *Iₛₑₜ₂* is obtained by processing the current of the first DC/DC conversion circuit before stopping outputting the control signal. In other words, before the stopping outputting the control signal, the current *Iₚᵣₑ* at the power supply side of the first DC/DC conversion circuit is collected; and the first preset current *Iₛₑₜ₂* is then obtained by calculating the product of the current *Iₚᵣₑ* at the power supply side of the first DC/DC conversion circuit and a coefficient K.

Where, the coefficient K is set by the technicians in advance according to actual situation, for example, the coefficient K is set to be two.

In the process of implementing step S405, it is required to ascertain the current to determine whether voltage at the power supply side of the first DC/DC conversion circuit is resumed. On determining that the present current collected at the power supply side of the first DC/DC conversion circuit is less than the first preset current *Iₛₑₜ₂*, it is determined that the voltage at the power supply side of the first DC/DC conversion circuit is resumed, and step S406 is executed. In a case that the present current collected at the power supply side of the first DC/DC conversion circuit is greater than or equal to the first preset current *Iₛₑₜ₂*, S408 is executed.

In step S406, it is determined that an arc fault occurs.

In step S407, on determining that the arc fault occurs, alarm information is generated and output.

In the process of implementing steps S406 and S407, through the specific implementing process of steps S401 to S405, it may be determined that the suspected arc is a true arc phenomenon and can be eliminated, and there is no false elimination phenomenon, that is, the first DC/DC conversion circuit is an open circuit. Then alarm information is outputted for the user to perform processing.

In step S408, it is determined that no arc fault occurs.

In the process of implementing step S408, it is determined that the suspected arc detected is not an arc fault, that is, it is determined that no arc fault occurs on the first DC/DC conversion circuit.

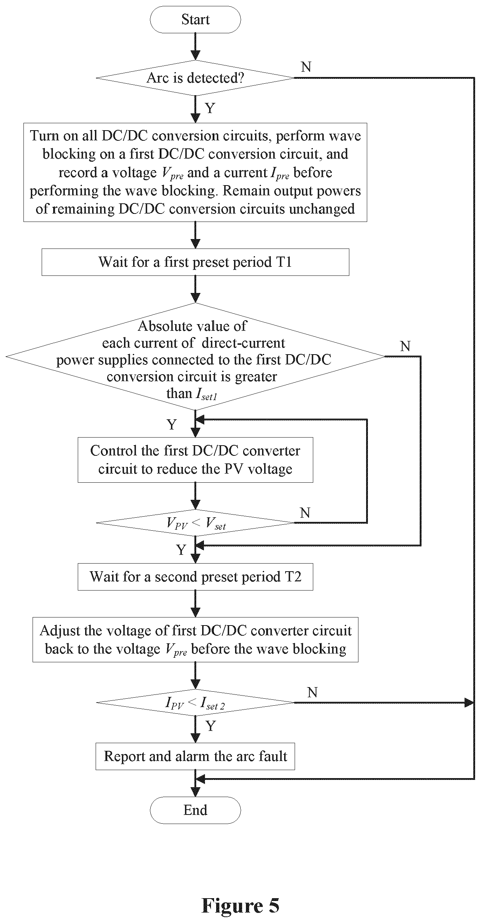

It should be noted that the specific implementation of the process for processing arc fault through steps S401 to S408 are shown in Figure 5.

According to an embodiment of the present disclosure, after the suspected arc is detected, the control signal is only stopped being outputted to the first DC/DC conversion circuit where the suspected arc occurs, resulting in minimum power fluctuation in an entire detection and control process, which does not impact on power generation quantity of a power station and a power grid. After waiting for the first preset period, on determining that the currents of all the direct-current power supplies connected to the power supply side of the first DC/DC conversion circuit are greater than the second preset current, the voltage at the power supply side of the first DC/DC conversion circuit is controlled to be less than the safety voltage to perform an arc extinguishing action to ensure that the arc burning can be extinguished. After waiting for the second preset period, the voltage at the power supply side of the first DC/DC conversion circuit is adjusted to the voltage before stopping outputting the control signal, to ensure that the arc phenomenon is reliably extinguished. On determining that the present current at the power supply side of the first DC/DC conversion circuit is less than the first preset current, the suspected arc is determined to be the arc fault, thereby improving the effect of arc phenomenon detection and eliminating the arc phenomenon.

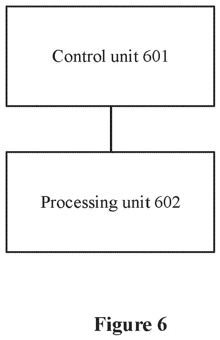

Based on the method for processing arc fault provided in the above embodiments of the present disclosure, correspondingly, a schematic structural diagram of a device for processing arc fault is provided according to an embodiment of the present disclosure, as shown in Figure 6. The device for processing arc fault is arranged in the controller shown above, and the device for processing arc fault includes a control unit 601 and a processing unit 602.

The control unit 601 is configured to stop outputting a control signal to a first DC/DC conversion circuit where a suspected arc occurs in a case that the suspected arc is detected, and maintain remaining DC/DC conversion circuits operating normally. In an embodiment, the control unit 601 may be a controller, which is not limited in the present disclosure.

Processing unit 602 is configured to determine whether a current at a power supply side of the first DC/DC conversion circuit is less than a first preset current after waiting for a first preset period, and determine that an arc fault occurs in a case that the current at the power supply side is less than the first preset current. In an embodiment, the processing unit 602 may be a processor, which is not limited in the present disclosure.

It should be noted that the specific principle and execution process of each unit of the device for processing arc fault provided in the above embodiments of the present disclosure are the same as the method for processing arc fault provided in the above embodiments of the present disclosure, which can be referred to the corresponding part of the method for processing arc fault provided in the above embodiments of the present disclosure, which will not be repeated herein.

According to an embodiment of the present disclosure, the control signal is only stopped being output to the first DC/DC conversion circuit where the suspected arc occurs, causing minimum power fluctuation in an entire detection and control process, which does not impact on power generation quantity of a power grid and a power station. By detecting the change of current in the first DC/DC conversion circuit, whether the suspected arc is the arc fault is determined. In a case that the current at the power supply side is less than the first preset current, it is determined that the arc fault occurs, thereby improving the effect of arc phenomenon detection.

In an embodiment, based on the device for processing arc fault provided in the above embodiment of the present disclosure. The processing unit 602 is further configured to determine whether each current of at least one direct-current power supply connected to the power supply side of the first DC/DC conversion circuit is greater than a second preset current respectively; and determine that an arc fault occurs, in a case that any current of the at least one direct-current power supply connected to the power supply side of the first DC/DC conversion circuit is less than the second preset current as well as the current at the power supply side is less than the first preset current.

In an embodiment, based on the device for processing arc fault provided in the above embodiment of the present disclosure, the processing unit 602 is further configured to: control a voltage at the power supply side of the first DC/DC conversion circuit to be less than a safety voltage, in a case that each current of the at least one direct-current power supply connected to the power supply side of the first DC/DC conversion circuit is greater than the second preset current; and wait for a second preset period, and adjust the voltage at the power supply side of the first DC/DC conversion circuit to be a voltage value before stopping outputting the control signal; and determine whether the current at the power supply side of the first DC/DC conversion circuit is less than the first preset current.

In an embodiment, based on the device for processing arc fault provided in the above embodiment of the present disclosure, the processing unit 602, which controls the voltage at the power supply side of the first DC/DC conversion circuit to be less than the safety voltage, is further configured to resume outputting the control signal to the first DC/DC conversion circuit, and adjust a duty ratio of the control signal, to enable the voltage at the power supply side of the first DC/DC conversion circuit is less than the safety voltage.

In an embodiment, based on the device for processing arc fault provided in the above embodiment of the present disclosure, the processing unit 602, which determines whether each current of the at least one direct-current power supply connected to the power supply side of the first DC/DC conversion circuit is greater than the second preset current respectively, is further configured to: calculate an absolute value of each current of the at least one direct-current power supplies connected to the power supply side of the first DC/DC conversion circuit; and determine whether a minimum value among the absolute values is greater than the second preset current.

In an embodiment, based on the device for processing arc fault provided in the above embodiment of the present disclosure, the control unit 601, which maintains remaining DC/DC conversion circuits operating normally, is further configured to: remain the operating powers of the remaining DC/DC conversion circuits unchanged.

In an embodiment, based on the device for processing arc fault provided in the above embodiment of the present disclosure, after determining whether the current at the power supply side of the first DC/DC conversion circuit is less than the first preset current, the processing unit 602 is further configured to: determine that no arc fault occurs, in a case that the current at the power supply side is greater than or equal to the first preset current.

In an embodiment, based on the device for processing arc fault provided in the above embodiment of the present disclosure, the processing unit 602 is further configured to: record, in a case that the suspected arc is detected, a voltage value and a current value of the first DC/DC conversion circuit where the suspected arc occurs.

In an embodiment, based on the device for processing arc fault provided in the above embodiment of the present disclosure, the processing unit 602 is further configured to: generate and output alarm information, on determining that the arc fault occurs.

The embodiments in the present disclosure are described in a progressive manner, the same and similar parts of the various embodiments in this specification can be referred to each other, and each embodiment focuses on the differences from other embodiments. In particular, for the system or the system embodiment, since it is basically similar to the method embodiment, the description is relatively simple. The related parts can refer to the part of the description of the method embodiment. The systems and system embodiments described above are merely illustrative, and the units described as separate components may or may not be physically separated, and the components shown as units may or may not be physical units, that is, they can be located in one place, or they can be distributed to multiple network elements. Part or all of the modules can be selected according to practical needs to achieve the purpose of the solution of this embodiment. It can be understood and implemented by those skilled in the art without creative efforts.

Professionals can further realize that the units and algorithm steps of the examples described in conjunction with the embodiments disclosed herein can be implemented by electronic hardware, computer software or a combination of the two. In order to clearly illustrate the possible interchangeability of the hardware and software, in the above description, the composition and steps of each example have been generally described according to their functions. Whether these functions are executed by hardware or software depends on the specific applications and design constraints of the technical solution. Those skilled in the art may use different methods to implement the described functions for each specific application, but such implementation should not be regarded as beyond the scope of the present disclosure.

According to the above description of the disclosed embodiments, those skilled in the art can realize or use the present disclosure. Various modifications to these embodiments will be readily apparent to those skilled in the art, and the general principles defined herein may be applied to other embodiments without departing from the spirit or scope of the present disclosure. Hence, the present disclosure should not be limited to the embodiments disclosed herein, rather, has the widest scope in accordance with the principle and the novel features disclosed herein.

## Claims

1. A method for processing arc fault, applied to an inverter, wherein the inverter comprises an inversion circuit and at least one DC/DC conversion circuit connected to a direct-current side of the inverter, wherein the method comprises:
in a case that a suspected arc is detected, stopping outputting a control signal to a first DC/DC conversion circuit where the suspected arc occurs, and maintaining remaining DC/DC conversion circuits operating normally;
waiting for a first preset period, and determining whether a current at a power supply side of the first DC/DC conversion circuit is less than a first preset current; and
determining that an arc fault occurs, in a case that the current at the power supply side is less than the first preset current.

2. The method according to claim 1, wherein after waiting for the first preset period and before the determining whether the current at the power supply side of the first DC/DC conversion circuit is less than the first preset current, the method further comprises:
determining whether each current of at least one direct-current power supply connected to the power supply side of the first DC/DC conversion circuit is greater than a second preset current respectively; and
in a case that any current of the at least one direct-current power supply connected to the power supply side of the first DC/DC conversion circuit is less than the second preset current, determining whether the current at the power supply side of the first DC/DC conversion circuit is less than the first preset current.

3. The method according to claim 2, wherein after the determining whether each current of the at least one direct-current power supply connected to the power supply side of the first DC/DC conversion circuit is greater than the second preset current respectively, and before the determining whether the current at the power supply side of the first DC/DC conversion circuit is less than the first preset current, the method further comprises:
controlling a voltage at the power supply side of the first DC/DC conversion circuit to be less than a safety voltage, in a case that each current of the at least one direct-current power supply connected to the power supply side of the first DC/DC conversion circuit is greater than the second preset current; and
waiting for a second preset period, and adjusting the voltage at the power supply side of the first DC/DC conversion circuit to be a voltage value before stopping outputting the control signal; and
determining whether the current at the power supply side of the first DC/DC conversion circuit is less than the first preset current.

4. The method according to claim 3, wherein the controlling the voltage at the power supply side of the first DC/DC conversion circuit to be less than the safety voltage comprises:
resuming outputting the control signal to the first DC/DC conversion circuit, and adjusting a duty ratio of the control signal, to enable the voltage at the power supply side of the first DC/DC conversion circuit is less than the safety voltage.

5. The method according to claim 2, wherein the determining whether each current of the at least one direct-current power supply connected to the power supply side of the first DC/DC conversion circuit is greater than the second preset current respectively comprises:
calculating an absolute value of each current of the at least one direct-current power supplies connected to the power supply side of the first DC/DC conversion circuit; and
determining whether a minimum value among the absolute values is greater than the second preset current.

6. The method according to any one of claims 1 to 5, wherein after determining whether the current at the power supply side of the first DC/DC conversion circuit is less than the first preset current, the method further comprises:
determining, in a case that the current at the power supply side is greater than or equal to the first preset current, that no arc fault occurs.

7. The method according to any one of claims 1 to 5, further comprising:
recording, in a case that the suspected arc is detected, a voltage value and a current value of the first DC/DC conversion circuit where the suspected arc occurs.

8. The method according to any one of claims 1 to 5, further comprising:
on determining that the arc fault occurs, generating and outputting alarm information.

9. An inverter, comprising a controller, an inversion circuit and at least one DC/DC conversion circuit, wherein
a power supply side of the at least one DC/DC conversion circuit, serving as an interface corresponding to a direct-current side of the inverter, is configured to be connected to at least one direct-current power supply;
a bus side of the DC/DC conversion circuit is connected to a direct-current side of the inversion circuit through a direct-current bus;
an alternating-current side of the inversion circuit, serving as an alternating-current side of the inverter, is configured to be connected to a power grid and/or an alternating-current load;
the controller is configured to control the inversion circuit and the DC/DC conversion circuit; and the controller is further configured to implement the method for processing arc fault according to any one of claims 1 to 8.

10. The inverter according to claim 9, the at least one direct-current power supply comprises a photovoltaic string or a battery cluster.

11. A photovoltaic system, comprising at least one photovoltaic string and the inverter according to claim 9, wherein
the interface corresponding to the direct-current side of the inverter is connected to the at least one photovoltaic string, and the alternating-current side of the inverter is connected to the power grid and/or the alternating-current load.

12. A device for processing arc fault, comprising:
a control unit, configured to stop outputting a control signal to a first DC/DC conversion circuit where the suspected arc occurs, and maintain remaining DC/DC conversion circuits operating normally, in a case that a suspected arc is detected;
a processing unit, configured to determine whether a current at a power supply side of the first DC/DC conversion circuit is less than a first preset current after waiting for a first preset period, and determine that an arc fault occurs, in a case that the current at the power supply side is less than the first preset current.

13. The device according to claim 12, wherein the processing unit is further configured to:
determine whether each current of at least one direct-current power supply connected to the power supply side of the first DC/DC conversion circuit is greater than a second preset current respectively; and
determine whether the current at the power supply side of the first DC/DC conversion circuit is less than the first preset current, in a case that any current of the at least one direct-current power supply connected to the power supply side of the first DC/DC conversion circuit is less than the second preset current.

14. The device according to claim 13, wherein the processing unit is further configured to:
control a voltage at the power supply side of the first DC/DC conversion circuit to be less than a safety voltage, in a case that each current of the at least one direct-current power supply connected to the power supply side of the first DC/DC conversion circuit is greater than the second preset current; and
wait for a second preset period, and adjust the voltage at the power supply side of the first DC/DC conversion circuit to be a voltage value before stopping outputting the control signal; and
determine whether the current at the power supply side of the first DC/DC conversion circuit is less than the first preset current.

15. The device according to claim 14, wherein the processing unit is further configured to:
resume outputting the control signal to the first DC/DC conversion circuit, and adjust a duty ratio of the control signal, to enable the voltage at the power supply side of the first DC/DC conversion circuit is less than the safety voltage.
